(19) Europäisches Patentamt
European Patent Office
Office européen des brevets

(11) **EP 4 650 172 A1**

(12) **EUROPEAN PATENT APPLICATION**

(43) Date of publication:
**19.11.2025 Bulletin 2025/47**

(21) Application number: **24175517.2**

(22) Date of filing: **13.05.2024**

(51) International Patent Classification (IPC):
***B33Y 80/00*** *(2015.01)*    ***C25D 1/10*** *(2006.01)*
***G03F 7/00*** *(2006.01)*

(52) Cooperative Patent Classification (CPC):
**B33Y 80/00; C25D 1/10; G03F 7/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **CSEM Centre Suisse d'Electronique et de Microtechnique SA  - Recherche et Développement**
**2002 Neuchâtel (CH)**

(72) Inventors:
• **BOUDOIRE, Florent**
  **2000 Neuchâtel (CH)**
• **LANI, Sébastien**
  **3210 Kerzers (CH)**
• **DESPONT, Michel**
  **1400 Cheseaux-Noréaz (CH)**

(74) Representative: **e-Patent SA**
**Rue Saint-Maurice 12**
**Case postale**
**2001 Neuchâtel 1 (CH)**

(54) **METHOD FOR THE MANUFACTURE OF A MOLD FOR MOLDING A METALLIC PART BY IMPLEMENTATION OF LIGA MOLDING STEPS**

(57)     A method for the manufacture of a mold for molding a metallic part is disclosed, comprising the steps of:
S1) Providing a substrate (1) having at least a top layer which is electrically conductive and defining a horizontal orientation,
S2) Implementing an AM operation to build a 3D structure (4), comprising a cavity (6) defining at least one steep elevation surface, and

S3) Implementing a vertical vapor deposition on said 3D structure (4), for conducting the deposition of an electrically conductive layer (30),
wherein the or at least one of the steep elevation surfaces is provided, at its end situated on the side of the cavity opening, with a overhanging rim (20, 22, 24; 42; 50) arranged so that the corresponding steep elevation surface is at least partially out of reach from said vertical vapor deposition during step S3.

**Fig. 3**

EP 4 650 172 A1

## Description

## Technical Field

The invention is in the field of the fabrication of metallic parts (including parts made of a metal alloy) by implementation of LIGA (Lithographie Galvanoformung und Abformung) molding technics.

More specifically, the invention relates to the manufacture of a mold adapted for molding a metallic part, possibly a multilevel metallic part, by implementation of standard LIGA molding steps, the method comprising the steps of:

S1) Providing a substrate having at least one portion with a substantially planar surface defining a horizontal orientation,
S2) Building an electrically non-conductive 3D structure on the planar surface, comprising at least one cavity extending above the planar surface, between a horizontal bottom surface and an opening surrounded by a top surface, the cavity defining at least one steep elevation surface, and
S3) Implementing a directional vapor deposition on the electrically non-conductive 3D structure, substantially along the vertical direction, with a vapor composition comprising at least one electrically conductive compound.

## State of the art

Historically, the LIGA technology also encompassed the manufacture of a mold, for molding metallic parts, by implementation of specific technics.

Document EP3547027A1 discloses steps of a typical LIGA method for building a mold, by using specific photoresist compounds, the mold having horizontal surfaces later covered with an electrically conductive layer or film, for instance containing gold. A standard LIGA electroplating or electrodeposition operation is then carried out to manufacture a multilevel metallic part, preferably made of NiP (Nickel-Phosphorus).

The present Applicant unveiled a new approach for building an appropriate mold, which was published on page 43 of the Scientific & Technical Report of the csem (a Swiss company), which can be downloaded through the following link: https://yoda.csem.ch/bitstream/handle/20.500.12839/24/CSEM-STR-2017.pdf?sequence=1&isAllowed=y.

As mentioned in this article, a new method to form metal millimeter scale components had been developed that benefited from the use of a digital based manufacturing technology (UV stereolithography) to build freeform molds for metal electroplating. This method comprises the steps S1 and S2 as mentioned above, presents the advantage of easy modification through mask design and is an essential element for creating complex metal parts on the millimeter scale.

However, whichever manufacturing technics is implemented to build the mold, a regular occurrence of defects was observed when standard LIGA steps were carried out to manufacture multilevel metallic parts, which can take the form of mushroom structures and/or empty cavities.

This problem was addressed in EP3547027A1. Indeed, it was observed that the issue mentioned above stemmed from the fact that the vertical walls or flanks were also covered with the electrically conductive film, resulting in continuity defects at the junctions between the horizontal and vertical walls. In fact, the implementation of a directional vapor deposition according to the vertical direction does not prevent the deposition of the corresponding electrically conductive compound on the vertical walls, as far as the envelope of the vapor flux has the shape of a cone with a small angle, due to the fact that the vapor ejection outlet has a limited transversal dimension in comparison to the typical transversal dimension of a wafer on which molds for the manufacture of metallic multilevel parts are built.

Different solutions to overcome this issue have been proposed in the past, as mentioned in this prior patent application. One of these solutions consists in applying a shadow mask on top of the mold before performing the directional vapor deposition, so as to protect the vertical walls from the electrically conductive compound during its vapor deposition. However, as correctly stated in this document, to be effective, the openings of the shadow mask must be slightly smaller than the horizontal surfaces to be covered, to prevent any spurious scattering that would deposit gold particles on the vertical flanks. This technique requires perfect alignment between the mold and the shadow mask which can be very difficult on medium sized molds as well as on large substrates. This technique does not allow a complete protection of the vertical walls for all mold geometries. All masking structures must indeed be connected to a frame of the shadow mask and may, as such, generate parasitic masking.

Neither this solution nor other solutions presented in EP3547027A1 have been found persuasive by the corresponding Applicant, who then proposed to conduct a standard directional vapor deposition before carrying out a controlled chemical attack to remove the conductive film from the vertical walls, before proceeding with the molding of the metallic multilevel part as such. It is interesting to note that this solution was still presented as an advantageous method by the same Applicant in a later patent application, EP3839627A1, filed 21 months after EP3547027A1.

## Disclosure of the invention

An aim of the present invention is to propose a method for manufacturing a mold, for molding a metallic part by implementation of standard LIGA molding steps, which is precise, reliable and as simple as possible in terms of number and complexity of the steps it comprises.

This aim is achieved by providing a method as mentioned above, further characterized in that the electrically non-conductive 3D structure is built by implementation of an AM (Additive Manufacturing) or 3D printing method, in step S2, in such a way that at least one of the steep elevation surfaces provided in the cavity is provided, at its end situated on the side of the cavity opening, with a peripheral overhanging rim, arranged in such a manner that the corresponding steep elevation surface is at least partially out of reach from the directional vapor deposition during implementation of step S3.

In the context of the present invention, "steep elevation surface" should be understood as a surface with a mean angle of $\pm 20°$ relative to the normal to the planar surface of the substrate.

The steep elevation surfaces concerned by the implementation of the method according to the present invention can be diversely arranged within the cavity, i.e. they can be defined by one or several substantially vertical surfaces constituting at least part of a peripheral envelope of the cavity and/or they can be defined as additional surfaces arranged inside the cavity when the latter exhibits a complex shape. For instance, if the mold is intended for molding multilevel metallic parts, the cavity may comprise several substantially horizontal levels (which may also be tilted in some extent, and which may be either flat or curved, or even 3D-textured) connected with each other by adapted steep elevation surfaces on top of one or several steep elevation surfaces defining the peripheral envelope of the cavity.

These features of the present invention provide an efficient protection of the concerned steep elevation surfaces during implementation of the directional vapor deposition, in an improved manner in comparison to the implementation of a shadow mask. Indeed, the proper positioning of the peripheral overhanging rims is carried out directly when they are built as far as they are integral with the 3D structure. Thanks to the implementation of AM technics to build the 3D structure, the latter can be built with a high precision level, providing a great control on the positioning and dimensioning of the peripheral overhanging rims, including an aptitude to precisely control the positioning and dimensioning of each overhanging rim, individually. It should further be highlighted that such peripheral overhanging rims cannot be built by standard LIGA building processes using a resin to build the 3D structure, as far as only straight vertical walls can be built with these technics, in other words no overhanging element can be built.

To avoid any misunderstanding in the subsequent description, it may be important to clarify that the indications regarding the orientations of the structures and walls are based on the use of the substrate as a reference. More precisely, the planar surface of the substrate on which the 3D structure is built defines a horizontal plane. Hence, the growth of the 3D structure is carried out along a vertical direction, which is then the general extension direction of the cavities in which the metallic parts will be molded later. As previously stated, the walls or envelopes of the cavities might also be more generally defined as steep elevation surfaces having a mean angle of $\pm 20°$ relative to the normal to the planar surface of the substrate.

Advantageously, the AM operation may be chosen from the group comprising stereolithography, preferably projection micro-stereolithography, two-photon polymerization, inkjet printing, preferably EHD Jet Printing, Direct Ink Writing and Robocasting.

The non-conductive 3D structure may preferably be made of a photosensitive resin such as an acrylate or an epoxy resin.

Advantageously, the planar surface of the substrate is electrically conductive or is at least partly covered with an electrically conductive layer before implementation of step S2, the electrically conductive layer preferably containing one or several metals taken from the group comprising gold, titanium, and chromium.

In general, the substrate may advantageously be made of metal, brass, silicium or glass, and the planar surface may preferably have a flatness below 50 $\mu$m.

According to another advantageous aspect, the vapor composition, in the implementation of step S3, may comprise one or several metals taken from the group comprising titanium, gold, copper and nickel.

According to another aspect, step S3 may be implemented in such a way that the top surface located around the cavity opening is also covered with an electrically conductive layer after the directional vapor deposition took place.

In general, it may be provided that, in step S2, at least two steep elevation surfaces are built which have different respective heights and/or inclination angles with respect to the vertical direction, as well as two corresponding peripheral overhanging rims extending from the corresponding steep elevation surfaces by different respective distances adapted to the different respective heights and/or in inclination angles, in such a manner that both steep elevation surfaces are at least partly out of reach from the directional vapor deposition during the implementation of step S3.

In general, it may be preferable to provide that steps S1 to S3 are implemented in such a way that a plurality of molds are manufactured at once, the substrate being a wafer having suitable dimensions to allow the manufacture of the plurality of molds thereon.

In that case, it might be advantageous to provide that each of the peripheral overhanging rims extends from the corresponding steep elevation surface by a distance d substantially equal to, or slightly bigger than h*D/2L, where h is the height of the corresponding steep elevation surface, D is the largest transversal dimension of the wafer, and L is the distance between the wafer and a vapor source used for the implementation of the directional vapor deposition of step S3.

In some cases, when a steep elevation surface presents an important height, it may be convenient to provide one or several additional overhanging rims distributed along the height of said steep elevation surface. In this manner, the top peripheral overhanging rim situated at the end of the steep elevation surface does not have to extend horizontally across a large distance d, sufficient to protect the whole height of the steep elevation surface from the directional vapor deposition during implementation of step S3. Instead, the top peripheral overhanging rim can extend across a shorter horizontal distance to protect only a fraction of the steep elevation surface's height, whereas one or several additional overhanging rims, provided at a lower level of the steep elevation surface, protect lower areas of said surface. This approach is advantageous for several reasons. First, as the overhanging rim is an integral part of the 3D-mold, it may have an impact on the final 3D-shape of the metallic part fabricated by the present method. It is therefore preferable that such structure is small and discrete. It may be noted that, in some cases, a further processing step may be implemented to remove from the fabricated metallic part the upper layers having the signature of the overhanging rim. Second, when the 3D mold takes the shape of a narrow, deep groove, the length of the overhanging rim which would be necessary to protect the whole height of the walls might be larger than the groove, blocking in such case all the vapor deposition into the groove. To avoid that, it is convenient to provide a distribution of one or several smaller overhanging rims across the groove's walls height.

The present invention further relates to a method for the manufacture of a metallic part, comprising the steps consisting in:

- providing a mold by implementing a method according to the above-mentioned features, and
- implementing standard LIGA molding steps, including creation of a metallic mass in the mold by galvanic growth and removal of the mold from the metallic mass to define the metallic part.

Advantageously, the above method may further include an intermediate step consisting in planarizing at least a portion of the metallic mass located outside the mold before the latter is removed from the planarized metallic mass.

**Brief description of the drawings**

Further details of the invention and other advantageous embodiments will appear more clearly upon reading the description below, in connection with the following figures which illustrate:

- Figs. 1 to 6: Schematic diagrams corresponding to different successive steps of a manufacturing method according to a preferred embodiment of the present invention, in chronological order,

- Figs. 7 and 8a, 8b and 8c: Schematic diagrams of geometrical parameters influencing details of implementation of the manufacturing method according to the present invention, and
- Figs. 9a, 9b, 9c and 9d: Schematic diagrams of molds according to alternative non-limiting exemplary embodiments of the present invention.

**Embodiments of the invention**

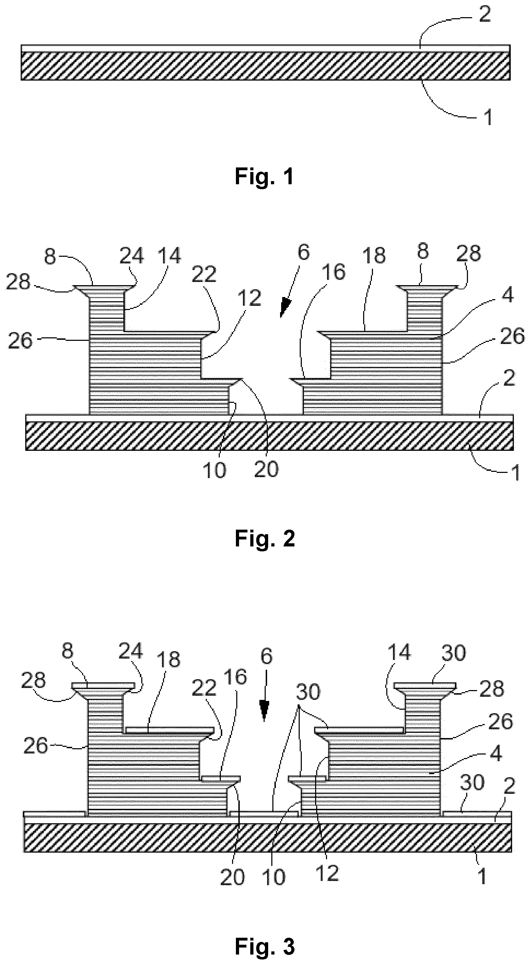

Figs. 1 to 6 are schematic diagrams illustrating different successive steps of a method for building a mold according to a preferred embodiment of the present invention, and then for molding a metallic part, in chronological order, the metallic part being here advantageously but non-limitingly of the multilevel kind.

Fig. 1 illustrates a first step S1 of providing an appropriate substrate 1 for building a mold according to the present invention. This substrate may be a wafer for instance, and it may advantageously be made of metal, brass, silicium or glass.

The substrate 1 preferably has at least a portion having a planar surface with a flatness below 50 $\mu$m to promote a good adhesion of the additively manufactured non-conducting mold.

As previously stated, the orientation of the planar surface of the substrate 1 defines a horizontal orientation for the purpose of describing the next coming fabrication steps and the full structure which will be obtained then.

When the substrate 1 is made of an electrically non-conductive material, it is coated with an electrically conductive layer or film 2, as illustrated in Fig. 1. The electrically conductive layer 2 may preferably contain one or several metals taken from the group comprising gold, titanium, and chromium.

For instance, it is possible to provide that a silicium substrate is covered, by evaporation, with a first layer of approximately 20 nm of titanium (not visible in Fig. 1) and with a second layer of approximately 200 nm of gold.

More generally, the nature of the electrically conductive layer depends on the metal which will be later used in the molding process. For instance, in the field of watchmaking, many parts are made of NiP and, in that case, gold is typically used as a main compound of the electrically conductive layer. For other application fields, it is for instance possible to use nickel, as a main compound of the electrically conductive layer, before molding parts made of nickel or of copper.

Thus, in any case, either the substrate 1 itself is electrically conductive or, at least a top layer of the portion of the substrate 1 defining the planar surface of interest is electrically conductive.

Apart from this and depending on the material of the electrically conductive layer and on the resin used later to build the mold, an additional adequate processing step might be necessary, like plasma cleaning, surface priming for adhesion, silanization, etc...

Fig. 2 illustrates step S2 consisting in building a 3D structure 4 by implementation of an adapted AM (Additive Manufacturing) method.

The AM method may preferably be chosen from the group comprising stereolithography, preferably projection micro-stereolithography, two-photon polymerization, inkjet printing, preferably EHD Jet Printing, Direct Ink Writing and Robocasting.

The AM method provides a higher freedom of design compared to the prior art methods described above, and the possibility of defining many layers or levels with a vertical resolution in the order of 5 $\mu$m.

A preferred embodiment of the method according to the present invention is to implement a projection micro-stereolithography of an acrylate-based resin. This resin can be prepared according to the formulation described by Gong et al. (https://pubs.rsc.org/en/content/articlehtml/2017/lc/c7lc00644f) or be a commercial resin such as the HTL resin from the company BMF (https://bmf3d.com/wp-content/uploads/2023/02/BMFHTLResinDatasheet_022823.pdf). It is however possible to use an epoxy-based resin as an alternative, without going beyond the scope of the present invention as defined by the appended set of claims.

The 3D structure 4 comprises at least one cavity 6 extending above said planar surface, here according to a vertical direction, between a horizontal bottom surface (corresponding to the uncovered electrically conductive layer 2) and an opening surrounded by a top surface 8.

If the cavity 6 may generally have only one level in the vertical direction to mold a basic part, or at least two distinct levels so as to be able to mold multilevel parts, it has three different levels here, for a non-limiting illustrative purpose. Each level is defined by a peripheral vertical envelope 10, 12 and 14, the envelopes of two adjacent levels being connected to each other by substantially horizontal surfaces 16, 18.

As previously stated, if each envelope 10, 12, 14 is defined here by a vertical wall or surface, it can be provided more generally that each envelope is defined by a steep elevation surface having a mean angle or inclination of ± 20° relative to the normal to the planar surface of the substrate 1 on which the 3D structure is built.

As appearing from Fig. 2, thanks to the implementation of an AM method, it is possible to provide each peripheral vertical envelope 10, 12 and 14 with a peripheral overhanging rim 20, 22 and 24, with a high precision both in the positioning and in the dimensioning of these rims.

Additional overhanging rims 28 have been illustrated on the outside peripheral vertical walls 26 of the 3D structure 4, for a non-limiting illustrative purpose, as far as these walls 26 might be part of other adjacent cavities. Indeed, more generally, the method of manufacture according to the present invention also relates to the simultaneous fabrication of a plurality of molds for molding metallic parts. Thus, a plurality of molds can be built at once and then a plurality of metallic parts can be molded at once, for instance on a same wafer defining a common substrate for all the molds.

It appears from a comparison between the illustrations of Fig. 2 and of Fig. 3 that the provision of these peripheral overhanging rims 20, 22 and 24 in the cavity 6 offers a protection for the peripheral vertical envelopes 10, 12 and 14 during a next stage of directional vapor deposition S3 the result of which is illustrated on Fig. 3. Preferably, each overhanging rim has a shape, in its horizontal plane, corresponding to the shape of the vertical envelope it is associated with in its transverse (horizontal) section.

Consequently, all the peripheral vertical envelopes 10, 12 and 14 are shadowed by the peripheral overhanging rims 20, 22 and 24 during the directional vapor deposition, such that they are at least partially out of reach from the vapor deposition, and only the horizontal surfaces located inside the cavity 6 which are visible through the opening of the cavity 6 are covered with an electrically conductive layer 30. The covered horizontal surfaces thus include the horizontal surfaces 16 and 18, connecting the peripheral vertical envelopes 10, 12 and 14 to each other, as well as the portion of the electrically conductive layer 2 defining the bottom of the cavity 6. The top surface 8 of the 3D structure 4 is also covered here in the directional vapor deposition step S3, in a non-limiting manner.

As an illustrative non-limiting example, it is possible to provide a two-stage deposition, comprising a first deposition, for instance, of a 1-100 nm titaniumbased layer (not visible in Fig. 3) followed by a second deposition, for instance, of a 5-1000 nm layer of gold.

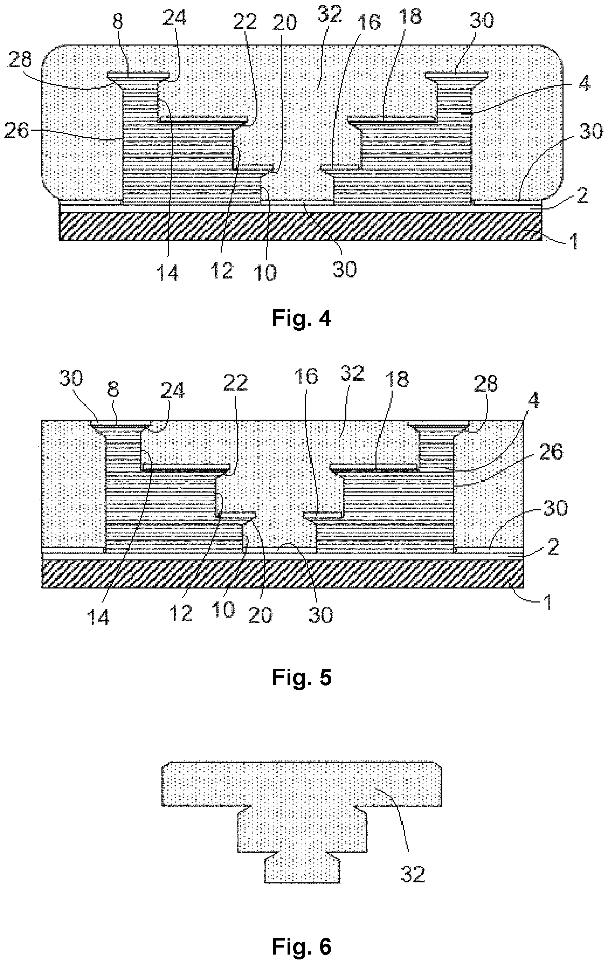

Implementation of the preceding steps S1 to S3, thus provides a mold which is ready to be used for molding a metallic part by implementing standard LIGA molding steps, as illustrated in Figs. 4 to 6.

As illustrated in Fig. 4, a metallic mass 32 may be created by galvanic growth inside the cavity 6 as a step S4. For instance, this metallic mass 32 may be made from nickel or NiP, with a typical thickness of the order of 0.4 to 1.5 mm (non-limiting examplary range).

In a known manner, this galvanic growth may be carried out by placing an electrical contact on an exposed surface of the electrically conductive layer 2 deposited in step S1, outside the 3D structure 4. This assembly forms a working electrode, which is then positioned opposite a counter electrode in a bath containing Ni2+ ions and a source of phosphorus. A known quantity of charges is then transferred between these electrodes, this quantity being calculated on the basis of the horizontal surfaces exposed in the mold and of the final thickness of the grown metallic mass.

An optional planarization step S5 may be implemented then the result of which is illustrated in Fig. 5. This planarization step can be carried out by any adapted standard method, like CMP (Chemical Mechanical Planarization) or diamond turning. A thickness of the order of a few tens of micrometers can be removed by implementation of this planarization step S5.

The metallic multilevel part resulting from the planarization of the metallic mass 32 can then be isolated by removal of the mold, including the initial substrate 1.

The removal of the mold can be carried out by any adapted standard method. For instance, the 3D structure 4 can be removed by chemical or plasma etching (with O2/CF4) or by thermal degradation, depending on the metal used to build the metallic multilevel part, while the substrate 1 may be removed by chemical etching (KOH bath for instance) or by plasma etching, for example with $O_2$ - $CF_4$.

Of course, additional steps might be carried out without going beyond the scope of the invention as defined by the appended set of claims. For instance, it might be recommended or necessary to carry out a cleaning step of the metallic multilevel part after removal of the mold.

The size of the parts manufactured by implementing the method of the present invention can vary from tens of micrometers to several centimeters in the XY (horizontal) plane. In the Z (vertical) direction, the component size can range from tens of micrometers to a few millimeters. The lower limits are determined by the printing resolution of the AM method. The upper limit in the XY plane is determined by the maximum printing area, which commonly does not exceed $10 \times 10$ cm at this resolution (approx. 5 $\mu$m). The upper limit in the Z direction is determined by the time required for electroforming. With a typical filling rate of around 1 $\mu$m/min, thicknesses greater than 1 mm take several tens of hours and become limiting factors for production.

Contrary to the limited prior fabrication method of multilayered standard photolithography, overhang structures can be easily fabricated on the edges of the openings of the mold according to the present invention, which cast a shadow on the vertical walls during the directional vapor deposition process as previously described.

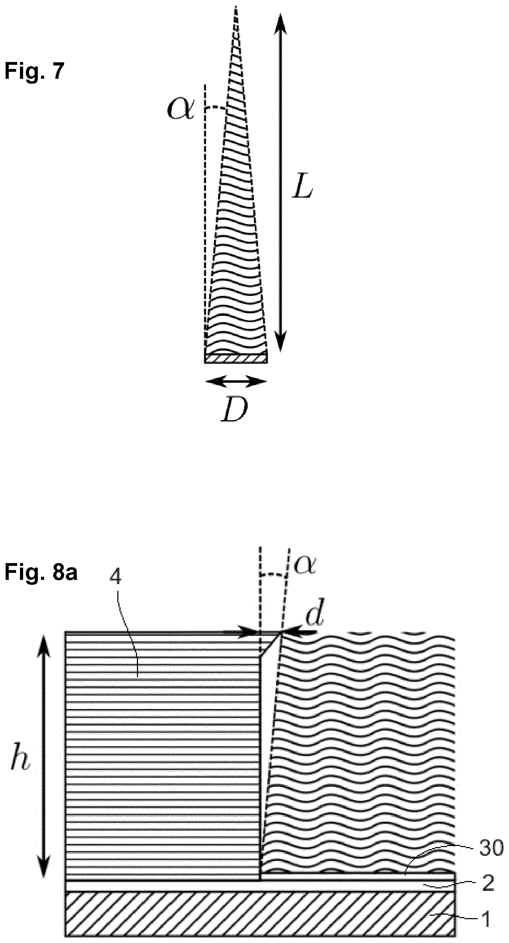

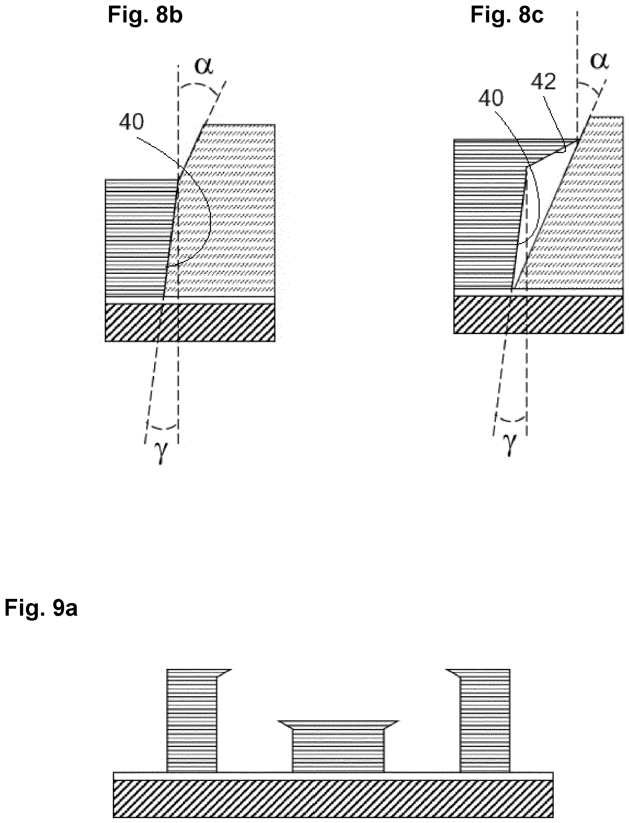

The illustrations of Fig. 7 and 8a, 8b, 8c allow a better understanding of how the size and shape of the overhanging rims according to the present invention should be defined, so that they extend far enough, away from the corresponding steep elevation surface or wall, to form an angle with respect to the base of the wall preferably slightly greater than the divergence angle of the directional vapor deposition.

Fig. 7 more particularly illustrates how the directional vapor deposition is carried out at the scale of a wafer. As far as the transversal dimension of the outlet of the vapor source is quite smaller than the transversal dimension of a wafer, the vapor flux defines a cone between its source and the wafer.

As represented in Fig. 7, D is defined as the transversal dimension of the wafer and L is the distance between the vapor source and the wafer, while $\alpha$ is the angle between the vapor cone envelope and the vertical direction at the periphery of the wafer. Of course, the incidence angle of the vapor is close to 0 in the central portion of the wafer.

Fig. 8a now illustrates a 3D structure 4 which is located close to the periphery of the wafer, where the incidence angle $\alpha$ of the vapor is maximum with respect to the substrate 1, h being the height of a given peripheral vertical envelope or wall to protect, and d being the distance to which the corresponding peripheral overhanging rim needs to extend in order to efficiently protect the vertical wall.

The dimension of the peripheral overhanging rim is defined by the corresponding geometrical relationships:

$$d = h \tan(\alpha)$$

$$\alpha = \arctan\left(\frac{D}{2L}\right)$$
$$d = \frac{hD}{2L}$$

To provide a rough estimate, here are typical values for these dimensions: L = 1 m and D = 10 cm (4-inch wafer). In this case, the peripheral overhanging rim size should be at least 5% of the vertical wall height to be protected. With typical wall heights ranging from 100 to 500 $\mu$m, the overhanging rim sizes are in the range of 5 to 25 $\mu$m.

In general, the distance of extension of the overhanging rims can be slightly smaller or bigger than the calculated value which implies that, in the first case, the bottom of the corresponding vertical wall might be slightly covered with the electrically conductive layer deposited through the directional vapor deposition, while in the second case, the edge of the horizontal surfaces located close to the vertical walls will not be fully covered with the electrically conductive layer deposited through the directional vapor deposition.

Still in general, a mold built according to the present invention may comprise at least two steep elevation surfaces having different respective heights and/or inclination angles with respect to the vertical direction. It might be preferable then to provide two corresponding peripheral overhanging rims, extending from the corresponding steep elevation surfaces by different respective distances adapted to the different respective heights and/or inclination angles, in such a manner that both steep elevation surfaces are at least partly out of reach from the directional vapor deposition during the implementation of step S3. Indeed, the implementation of an AM operation in step S2 provides a great flexibility in designing and building a plurality of peripheral overhanging rims with individual or customized parameters adapted to the specifics of the corresponding steep elevation surfaces.

Figs. 8b and 8c relate to the case where a steep elevation surface 40 is slightly inclined by an angle $\gamma$ with respect to the normal to the substrate 1. As mentioned above, the method according to the present invention still makes sense for steep elevation surfaces which are not strictly vertical but have an inclination $\gamma$ of $\pm$ 20° relative to the normal to the planar surface of the substrate 1.

It appears from Fig. 8b that, also in the case where $\gamma$ is smaller than the angle $\alpha$ of the vapor cone envelope, the corresponding steep elevation surface 40 is within reach of the vapor deposition. Thus, an overhanging rim 42 according to the present invention may advantageously be provided, as illustrated in Fig. 8c, to shadow the steep elevation surface 40 such that it is out of reach of the vapor deposition.

We understand that a steep elevation surface with an opposite inclination than the one illustrated in Figs. 8b and 8c might still be at least partially protected according to the present invention, by providing an overhanging rim with a longer extent in the horizontal plane.

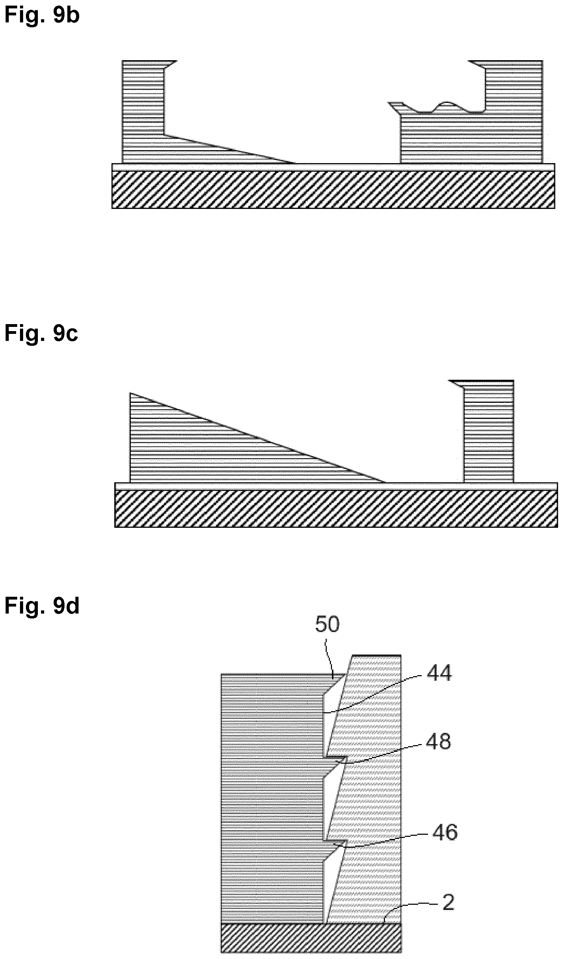

Finally, Figs. 9a, 9b, 9c and 9d illustrate further non-limiting examplary embodiments of molds according to the present invention.

The schematic diagrams of Figs. 9a and 9b illustrate examples of molds where shadowed steep elevation surfaces are implemented within the corresponding cavities, on top of peripheral envelopes, while the diagrams of Figs. 9b and 9c illustrate examples of molds having surfaces in the corresponding cavities which are not strictly horizontal (but tilted in Figs. 9b and 9c and curved or 3D-textured in Fig. 9b).

The schematic diagram of Fig. 9d illustrates a further non-limiting exemplary embodiment, together with the cone drawn by the vapor flux during implementation of step S3), and according to which a steep elevation surface 44 is provided with (one or) several additional peripheral overhanging rims 46, 48, each at a height level situated between the horizontal bottom surface 2 and its end situated on the side of the corresponding cavity opening.

Indeed, as already mentioned earlier, with a steep elevation surface 44 presenting an important height, it may be convenient to provide one or several additional overhanging rims 46, 48 distributed along the height of the steep elevation surface 44. In this manner, the top peripheral overhanging rim 50 situated at the end of the steep elevation surface 44 does not have to extend horizontally across a large distance d, sufficient to protect the whole height of the steep elevation surface 44 from the directional vapor deposition during implementation of step S3. Instead, the top peripheral overhanging rim 50 can extend across a shorter horizontal distance to protect only a fraction of the steep elevation surface's height, whereas the additional overhanging rims 46 and 48, provided at a lower level of the steep elevation surface 44, protect lower areas of the surface 44. In this case, the relevant height h of the steep elevation surface to be used to calculate the dimension of each peripheral overhanging rim 46, 48, 50 is to be considered from the bottom of the concerned surface, the bottom corresponding to the additional overhanging rim situated immediately below when there is one.

The one skilled in the art will encounter no particular difficulty to adjust the shape of the rims and the value of d as a function of his needs and of the different materials used for building the different areas of the mold and/or the metallic mass, without going beyond the scope of the present invention as defined by the appended set of claims.

**Claims**

1. Method for the manufacture of a mold for molding a metallic part by implementation of standard LIGA molding steps, the method comprising the steps of:

    S1) Providing a substrate (1), having at least one portion with a substantially planar surface defining a horizontal orientation and at least a top layer of which being electrically conductive,
    S2) Building an electrically non-conductive 3D structure (4) on said planar surface, comprising at least one cavity (6) extending above said planar surface, between a horizontal bottom surface (2) and an opening surrounded by a top surface (8), said cavity (6) defining at least one steep elevation surface (10, 12, 14; 40; 44...), and
    S3) Implementing a directional vapor deposition on said electrically non-conductive 3D structure (4), substantially along the vertical direction, with a vapor composition comprising at least one electrically conductive compound,
    the method being **characterized in that** said electrically non-conductive 3D structure (4) is built by implementation of an AM (Additive Manufacturing) operation, in step S2, in such a way that at least one of said at least one steep elevation surface is provided, at its end situated on the side of the cavity opening, with a peripheral overhanging rim (20, 22, 24; 42; 50) arranged in such a manner that said at least one of said at least one steep elevation surface is at least partially out of reach from said directional vapor deposition during the implementation of step S3.

2. Method according to claim 1, **characterized in that** said AM operation is chosen from the group comprising stereolithography, preferably projection microstereolithography, two-photon polymerization, inkjet printing, preferably EHD Jet Printing, Direct Ink Writing and Robocasting.

3. Method according to claim 1 or 2, **characterized in**

that said non-conductive 3D structure (4) is made of a photosensitive resin such as an acrylate or an epoxy resin.

4.  Method according to any of the preceding claims, **characterized in that** said planar surface is electrically conductive or is at least partly covered with an electrically conductive layer (2) before implementation of step S2, said electrically conductive layer (2) preferably containing one or several metals taken from the group comprising gold, titanium, and chromium.

5.  Method according to any of the preceding claims, **characterized in that** said substrate (1) is made of metal, brass, silicium or glass.

6.  Method according to any of the preceding claims, **characterized in that** said planar surface has a flatness below 50 μm.

7.  Method according to any of the preceding claims, **characterized in that** said vapor composition comprises one or several metals taken from the group comprising titanium, gold, copper and nickel.

8.  Method according to any of the preceding claims, **characterized in that** said step S2 is implemented so as to carry out the deposition of a layer of titanium and of a layer of gold on said electrically non-conductive 3D structure (4).

9.  Method according to any of the preceding claims, **characterized in that** said step S3 is implemented in such a way that said top surface (8) is also covered with an electrically conductive layer (30) after said directional vapor deposition took place.

10. Method according to any of the preceding claims, **characterized in that**, in step S2, at least two steep elevation surfaces (44) are built which have different respective heights and/or inclination angles with respect to the vertical direction, as well as two corresponding peripheral overhanging rims (20, 22, 24; 42; 50) extending from the corresponding steep elevation surfaces (44) by different respective distances adapted to said different respective heights and/or in inclination angles, in such a manner that both steep elevation surfaces (44) are at least partly out of reach from said directional vapor deposition during the implementation of step S3.

11. Method according to any of the preceding claims, **characterized in that**, in step S2, at least one of said at least one steep elevation surface (44) is provided with one or several additional peripheral overhanging rims (46, 48), each at a height level situated between said horizontal bottom surface (2) and its end situated on the side of the corresponding cavity opening.

12. Method according to any of the preceding claims, **characterized in that** said steps S1 to S3 are implemented in such a way that a plurality of molds are manufactured at once, said substrate being a wafer having suitable dimensions to allow the manufacture of said plurality of molds thereon.

13. Method according to claim 12, **characterized in that** each of said peripheral overhanging rims (20, 22, 24) extends from the corresponding steep elevation surface by a distance d substantially equal to, or slightly bigger than h*D/2L, where h is the height of said corresponding steep elevation surface, D is the largest transversal dimension of said wafer, and L is the distance between said wafer and a vapor source used for the implementation of said directional vapor deposition of step S3.

14. Method for the manufacture of a metallic part, comprising the steps consisting in:

    - providing a mold by implementing a method according to any of claims 1 to 13, and
    - implementing standard LIGA molding steps, including creation of a metallic mass (32) in said mold by galvanic growth (S4) and removal (S6) of said mold from said metallic mass (32) to define said metallic part.

15. Method according to claim 14, **characterized in that** it further includes an intermediate step (S5) consisting in planarizing at least a portion of said metallic mass (32) located outside said mold before the latter is removed from the planarized metallic mass (32).

EP 4 650 172 A1

**Fig. 1**

**Fig. 2**

**Fig. 3**

**Fig. 4**

**Fig. 5**

**Fig. 6**

**Fig. 7**

**Fig. 8a**

**Fig. 8b**

**Fig. 8c**

**Fig. 9a**

**Fig. 9b**

**Fig. 9c**

**Fig. 9d**

Europäisches
Patentamt
European
Patent Office
Office européen
des brevets

# EUROPEAN SEARCH REPORT

**Application Number**

EP 24 17 5517

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 350 437 A1 (RICHEMONT INT SA [CH]) 10 April 2024 (2024-04-10) * abstract * * paragraph [0001] * * paragraph [0010] * * paragraph [0023] - paragraph [0025] * * paragraph [0114] - paragraph [0133] * * figures 34-39 * ----- | 1-15 | INV. B33Y80/00 C25D1/10 G03F7/00 |
| A,D | Dunan B. ET AL: "3D LIGA", CSEM Scientific and Technical Report 2017, 31 December 2017 (2017-12-31), pages 43-43, XP093214869, Retrieved from the Internet: URL:https://csem.cdn.prismic.io/csem/f93e3 215-3bb8-4acb-af27-9e1f4c69ef4f_CSEM-STR-2 017.pdf [retrieved on 2024-10-15] * the whole document * ----- | 1-15 | |
| | | | TECHNICAL FIELDS SEARCHED (IPC) |
| | | | B33Y G03F C23C C25D |

The present search report has been drawn up for all claims

| Place of search | Date of completion of the search | Examiner |
|---|---|---|
| The Hague | 15 October 2024 | Lozza, Monica |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 650 172 A1**

## ANNEX TO THE EUROPEAN SEARCH REPORT
## ON EUROPEAN PATENT APPLICATION NO.

EP 24 17 5517

15-10-2024

| Patent document cited in search report | Publication date | Patent family member(s) | Publication date |
|---|---|---|---|
| EP 4350437 A1 | 10-04-2024 | EP 4350437 A1 | 10-04-2024 |
| | | EP 4350439 A1 | 10-04-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3547027 A1

- EP 3839627 A1